# EUROPEAN PATENT APPLICATION

(11) **EP 4 722 741 A1**
(43) Date of publication of application: **08.04.2026**
(21) Application number: 24204701.7
(22) Date of filing: 04.10.2024
(51) Int. Cl.: G01R 27/02

(54) **COMPUTER SYSTEM AND METHOD FOR VOLTAGE MEASUREMENTS**

(71) Applicant: Volvo Truck Corporation, 405 08 Göteborg (SE)
(72) Inventor: NEILSON, Rohan, VÄSTERÅS (SE); BARKAH, Dani, ESKILSTUNA (SE); CARNEVALI, Alessandro, ESKILSTUNA (SE)
(74) Representative: Ström & Gulliksson AB

(57) **Abstract**

A computer system comprising processing circuitry is provided. The computer system is configured to: obtain a chassis voltage (V1) between a first traction voltage pole (A) and a chassis (P) of a vehicle (1); obtain a scheduled switching time (Ts) to switch from the first traction voltage pole (A) to the second traction voltage pole (B) in order to measure the chassis voltage (V2) between the second traction voltage pole (B) and the chassis (P) of the vehicle (1); determine a disturbance on the first or second voltage pole; adjust the scheduled switching time (Ts) and/or a corrective algorithm; and obtain a chassis voltage (V2) between the second traction voltage pole (B) and the chassis (P) of the vehicle (1) based on the adjusted scheduled switching time (Ts) and/or the corrective algorithm.

## Description

### TECHNICAL FIELD

The disclosure relates generally to electrical systems. In particular aspects, the disclosure relates to computer systems and methods for voltage measurements. The disclosure can be applied to heavy-duty vehicles, such as trucks, buses, and construction equipment, among other vehicle types. Although the disclosure may be described with respect to a particular vehicle, the disclosure is not restricted to any particular vehicle.

### BACKGROUND

Isolation resistance measurement is commonly performed in vehicles in order to determine the resistance to current leakage from a vehicle voltage bus to the chassis of the vehicle. Such measurements are typically performed by alternately connecting the positive and negative poles of the traction voltage bus of the vehicle to the chassis via known safe resistances and analyzing the relative voltage shift achieved.

Due to capacitance effects and the need to keep leakage current safely low this process takes some time. Running a lower switching frequency gives a good accuracy but a poor response time which can compromise safety and reduce the value of an accurate reading whereas a higher switching frequency gives the opposite problem.

Isolation resistance monitoring devices can adapt their switching frequency to an optimized value based on the observed capacitance of the system and can even further shorten the switching frequency by projecting the swing curve to a logical asymptote and cutting it short rather than waiting for it to stabilize.

However, the voltage curve resulting from an isolation resistance measurement is naturally disturbed when a change occurs in the system. A good example of this is a battery contactor closing and suddenly reducing the resistance. The isolation resistance monitoring device becomes temporarily uncertain, particularly on the pole not currently being measured. This significantly increases the risk for false flags and capacitance calculations and curve projections are likely to return an error or be significantly impacted.

Based on the above, there is a need for improved approaches to isolation resistance monitoring in vehicles.

### SUMMARY

According to a first aspect of the disclosure, a computer system is provided. The computer system comprises processing circuitry configured to: obtain a chassis voltage between a first traction voltage pole and a chassis of a vehicle; obtain a scheduled switching time to switch from the first traction voltage pole to the second traction voltage pole in order to measure the chassis voltage between the second traction voltage pole and the chassis of the vehicle; determine a disturbance on the first or second traction voltage pole; adjust the scheduled switching time and/or a correction algorithm; and obtain a chassis voltage between the second traction voltage pole and the chassis of the vehicle based on the adjusted scheduled switching time and/or the correction algorithm. The first aspect of the disclosure may seek to improve accuracy for isolation resistance monitoring. A technical benefit may include reducing measurement faults and errors in interpreting measurement data.

Optionally in some examples, including in at least one preferred example, the processing circuitry is further configured to determine the disturbance as a scheduled disturbance or an occurring disturbance on the first or second traction voltage pole. A technical benefit may include preventing or at least reducing measurement faults.

A component can announce its disturbance to the voltage bus and the nature of the disturbance. Isolation resistance monitoring can then elect to adapt or reset its switch timing and/or adapt its calculation, using a corrective algorithm, to correct for this. In some examples it may simply be ignored. Dependence is not required and both forward and backward compatibility are thus possible.

A disturbance may be determined from a negative contactor only, with no voltage. Such example may be realized by a fuel cell system without voltage and therefore the entire fuel cell stack is connected to negative pole voltage. Vehicle positive pole resistance is unchanged and full stack resistance appears on negative pole. Isolation resistance calculation can thus be made using a corrective algorithm, ignoring the last voltage and use last resistance from the positive voltage pole (i.e. keeping the resistance constant).

A disturbance may be determined from a precharge on the positive pole, while the negative contactor is closed. The total resistance is staying essentially constant and voltage movement reflects changing asymmetry. Isolation resistance calculation can thus be made using a corrective algorithm, comparing the voltage shift and use the resistance on the positive pole as being equal to the resistance on the negative pole.

A disturbance may be determined from a resistance decrease, expected to be symmetrical. Such example may occur when a battery is connected to the voltage bus after balancing. Component positive pole matches vehicle positive pole when negative contactor closes despite the positive pole being open (hence positive already leaks as if positive was closed). In such example a corrective algorithm may be used, setting the resistance on the positive pole as being equal to the resistance on the negative pole.

Preferably, where devices or components must make an unscheduled change, shift, or disturbance they should ideally alert the isolation resistance monitoring, allowing it to adapt its cycle, make a compensation, or make a more informed decision regarding a measurement which might have been predictably affected. Capacitance and projection optimizations may be adapted or suppressed.

The isolation resistance monitoring may opt to use these alternative assumptions and calculations based on changing conditions it detects on the bus/network (e.g. known characteristics) or more preferentially in response to being notified of such an event/change (by the component, system, or controller), the nature of this change, and potentially even further information such as the internal voltage of the component making the change.

A technical benefit is to avoid predictable transient errors allowing systems or operators to detect and respond faster to problems for a safety improvement while also being able to operate more of a "hair trigger" due to reduced the risk of false positives. It can also aid/improve calculations based on output changes of the isolation resistance monitoring.

In response to the disturbance the isolation resistance monitoring may adapt its switching. In some cases this may be to accept a value prematurely and proceed and in others to hold and take an extra or updated value and potentially evaluate this shift. A conventional approach of adaptive switching may be to wait for a low dV/dt (relatively settled voltage after capacitance charging) before switching. The dV/dt may be upset by pre-charge or other voltage shift in the connected component causing the event, the dV/dt of which causes a corresponding dV/dt not relating to capacitance. A typical outcome is that switching on one pole terminates early and on the other pole being late and often halting causing the measuring process to halt. Another example is sharp conductivity changes in fuel cell coolant which will tend to have a symmetrical effect on the dV/dt asymptote. The dV/dt may therefore be assessed relative to the dV/dt expected from the event/conditions to allow it to continue, or switching may proceed with less adaptive timing, and in more complex examples a symmetric or asymmetrical dV/dt constant may be deduced.

A technical benefit is to prevent or reduce measurement halts for safety improvement and/or better values.

Optionally in some examples, including in at least one preferred example, the processing circuitry is further configured to obtain a time request for a predicted shift of the chassis voltage occurring at the scheduled switching time. A technical benefit may include the possibility to also adjust the time request, thereby optimizing the timing of voltage measurements.

Optionally in some examples, including in at least one preferred example, the processing circuitry is further configured to: determine that the time request for the predicted shift of the chassis voltage is within a predetermined time interval relative the scheduled switching time, and adjust at least one of the scheduled switching time and the time request such that the time request for the predicted shift of the chassis voltage is outside the predetermined time interval. A technical benefit may include more robust timing, not necessarily requiring exact points in time resulting in more accurate measurements.

Optionally in some examples, including in at least one preferred example, the processing circuitry is further configured to: obtain the time request for the predicted shift of the chassis voltage by obtaining a time request for an electrical connection of a vehicle component to the first traction voltage pole. A technical benefit may include reducing the impact of load connections when monitoring the characteristics of voltage poles and their associated electrical system.

Optionally in some examples, including in at least one preferred example, the processing circuitry is further configured to: adjust at least one of the scheduled switching time and the time request by delaying the scheduled switching time. A technical benefit may include a synchronized and efficient approach to improving measurements.

Optionally in some examples, including in at least one preferred example, the processing circuitry is further configured to: adjust at least one of the scheduled switching time and the time request by delaying the electrical connection of a vehicle component to the first traction voltage pole. A technical benefit may include a synchronized and efficient approach to improving measurements.

Optionally in some examples, including in at least one preferred example, the processing circuitry is further configured to: determine a time window, and adjust at least one of the scheduled switching time and the time request by effecting the switch from the first traction voltage pole to a second traction voltage pole and/or the electrical connection of a vehicle component to the first traction voltage pole within said time window. A technical benefit may include allowing the use of pre-determined, or dynamic, time windows to effect the scheduled switching time and/or the time request.

Optionally in some examples, including in at least one preferred example, the processing circuitry is further configured to: determine that the chassis voltage is swinging; wherein the time request for the predicted shift of the chassis voltage coincides with the swinging behavior of the chassis voltage. A technical benefit may include a robust and reliable approach to decide when synchronization is needed.

Optionally in some examples, including in at least one preferred example, the processing circuitry is further configured to: switch from the first traction voltage pole to a second traction voltage pole at a non-ideal shift of the obtained chassis voltage; obtain a chassis voltage between a second traction voltage pole and the chassis of the vehicle; and correct the obtained chassis voltage between the second traction voltage pole and the chassis of the vehicle based on the non-ideal shift of the obtained chassis voltage. A technical benefit may include reducing faulty measurements and their possible impact on system monitoring.

Optionally in some examples, including in at least one preferred example, the processing circuitry is further configured to: suppress the obtained chassis voltage between the second traction voltage pole and the chassis of the vehicle based on the non-ideal shift of the obtained chassis voltage. A technical benefit may include a simple and effective approach to improve measurement accuracy and reliability.

Optionally in some examples, including in at least one preferred example, the processing circuitry is further configured to: determine an isolation resistance between the first traction voltage pole and the chassis of the vehicle based on the measured chassis voltage, and determine an isolation resistance between the second traction voltage pole and the chassis of the vehicle based on the measured chassis voltage. A technical benefit may include providing useful data for system monitoring and performance optimization and control.

Optionally in some examples, including in at least one preferred example, the processing circuitry is further configured to: determine that the time request for the predicted shift of the chassis voltage is within a predetermined time interval relative the scheduled switching time, and adjust at least one of the scheduled switching time and the time request such that the time request for the predicted shift of the chassis voltage is outside the predetermined time interval and wherein the time request is synchronized with the chassis voltage being asymptotic: obtain the time request for the predicted shift of the chassis voltage by obtaining a time request for an electrical connection of a vehicle component to the first traction voltage pole; adjust at least one of the scheduled switching time and the time request by delaying the scheduled switching time; adjust at least one of the scheduled switching time and the time request by delaying the electrical connection of a vehicle component to the first traction voltage pole; determine a time window, and adjust at least one of the scheduled switching time and the time request by effecting the switch from the first traction voltage pole to a second traction voltage pole and/or the electrical connection of a vehicle component to the first traction voltage pole within said time window; determine that the chassis voltage is swinging; wherein the time request for the predicted shift of the chassis voltage coincides with the swinging behavior of the chassis voltage; switch from the first traction voltage pole to a second traction voltage pole at a non-ideal shift of the obtained chassis voltage; obtain a chassis voltage between a second traction voltage pole and the chassis of the vehicle; and suppress the obtained chassis voltage between the second traction voltage pole and the chassis of the vehicle based on the non-ideal shift of the obtained chassis voltage; and determine an isolation resistance between the first traction voltage pole and the chassis of the vehicle based on the measured chassis voltage, and determine an isolation resistance between the second traction voltage pole and the chassis of the vehicle based on the measured chassis voltage. A technical benefit may include applying an intelligent approach of identifying the chassis voltage to approaching a constant, and identifying such situation to be a reliable time for switching.

According to a second aspect of the disclosure, a vehicle is provided. The vehicle comprises the computer system of the first aspect. The second aspect of the disclosure may seek to improve accuracy for isolation resistance monitoring. A technical benefit may include optimized timing of voltage measurements, thereby reducing measurement faults and errors in interpreting measurement data.

Optionally in some examples, including in at least one preferred example, the vehicle further comprises a traction voltage bus comprising a first traction voltage pole and a second traction voltage pole, and an isolation resistance monitoring device configured to monitor the isolation resistance between the voltage bus and a chassis of the vehicle, and to selectively switch the connection between the first and second traction voltage poles. A technical benefit may include a useful, efficient, and reliable approach to obtain accurate monitoring of the isolation resistance.

According to a third aspect of the disclosure, a computer-implemented method is provided. The computer-implemented method comprises: obtaining, by processing circuitry of a computer system, a chassis voltage between a first traction voltage pole and a chassis of a vehicle; obtaining, by the processing circuitry, a scheduled switching time to switch from the first traction voltage pole to the second traction voltage pole in order to measure the chassis voltage between the second traction voltage pole and the chassis of the vehicle; obtaining, by the processing circuitry, a time request for a predicted shift of the chassis voltage occurring at the scheduled switching time; adjusting, by the processing circuitry, at least one of the scheduled switching time and the time request; and obtaining, by the processing circuitry, a chassis voltage between the second traction voltage pole and the chassis of the vehicle after the scheduled switching time. The third aspect of the disclosure may seek to improve accuracy for isolation resistance monitoring. A technical benefit may include optimized timing of voltage measurements, thereby reducing measurement faults and errors in interpreting measurement data.

Optionally in some examples, including in at least one preferred example, the method further comprises determining, by the processing circuitry, that the time request for the predicted shift of the chassis voltage is within a predetermined time interval relative the scheduled switching time, and adjusting, by the processing circuitry, at least one of the scheduled switching time and the time request such that the time request for the predicted shift of the chassis voltage is outside the predetermined time interval. A technical benefit may include more robust timing, not necessarily requiring exact points in time resulting in more accurate measurements.

Optionally in some examples, including in at least one preferred example, the method further comprises obtaining, by the processing circuitry, the time request for the predicted shift of the chassis voltage by obtaining a time request for an electrical connection of a vehicle component to the first traction voltage pole. A technical benefit may include reducing the impact of load connections when monitoring the characteristics of voltage poles and their associated electrical system.

Optionally in some examples, including in at least one preferred example, the method further comprises adjusting, by the processing circuitry, at least one of the scheduled switching time and the time request by delaying the scheduled switching time. A technical benefit may include a synchronized and efficient approach to improving measurements.

Optionally in some examples, including in at least one preferred example, the method further comprises adjusting, by the processing circuitry, at least one of the scheduled switching time and the time request by delaying the electrical connection of a vehicle component to the first traction voltage pole. A technical benefit may include a synchronized and efficient approach to improving measurements.

According to a fourth aspect of the disclosure, a computer program product is provided. The computer program product comprises program code for performing, when executed by the processing circuitry, the method of the third aspect. The fourth aspect of the disclosure may seek to improve accuracy for isolation resistance monitoring. A technical benefit may include optimized timing of voltage measurements, thereby reducing measurement faults and errors in interpreting measurement data.

According to a fifth aspect of the disclosure, a non-transitory computer-readable storage medium is provided. The non-transitory computer-readable storage medium comprises instructions, which when executed by the processing circuitry, cause the processing circuitry to perform the method of the third aspect. The fifth aspect of the disclosure may seek to improve accuracy for isolation resistance monitoring. A technical benefit may include optimized timing of voltage measurements, thereby reducing measurement faults and errors in interpreting measurement data.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

**FIG. 1** is an exemplary side view of a vehicle according to an example.
**FIG. 2** is an exemplary system diagram of an electrical system comprising an isolation resistance monitoring system according to an example.
**FIG. 3** is a series of diagrams showing different parameters obtained by an isolation resistance monitoring system according to an example.
**FIGS. 4A-B** are diagrams showing the switching operation of an isolation resistance monitoring system according to different examples.
**FIG. 5** is an exemplary system diagram of an isolation resistance monitoring system according to an example.
**FIG. 6** is another view of **FIG. 5****,** according to an example.
**FIG. 7** is an exemplary system diagram of an electrical system comprising an isolation resistance monitoring system according to an example.
**FIG. 8** is a flow chart of an exemplary method for voltage measurements according to an example.
**FIG. 9** is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

The present disclosure relates to computer systems and method for isolation monitor switching. The general idea is to identify that a shift in the chassis voltage, occurring at or close to a switch between which traction voltage pole is being monitored, will cause a disturbance that possibly will interfere with the isolation resistance monitoring leading to false or non-valid measurements. By adapting the calculation to reflect the assumptions which hold valid under the conditions, by making adjustments for predictable disturbances, and by modifying switching sequences and even the timing of the events themselves, the examples presented herein can reduce isolation resistance monitoring disturbance. The performance of diagnostic methods can be improved and additionally such diagnostic method will become more compatible with frequency shortening methods. This should deliver more safe and reliable systems and methods.

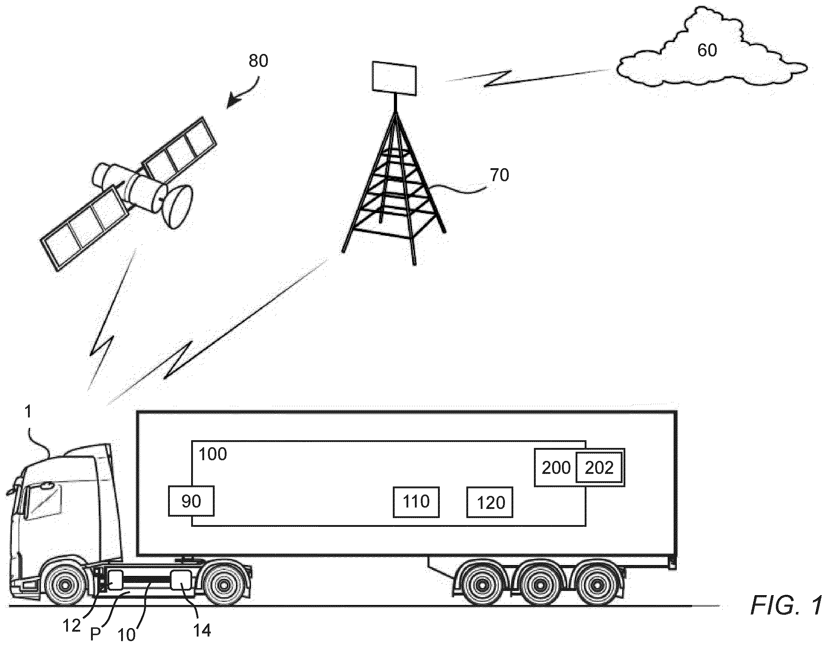

**FIG. 1** is an exemplary side view of a vehicle **1** according to an example. The vehicle **1** comprises at least one isolation resistance monitoring system **200.** The at least one isolation resistance monitoring system **200** is configured to determine the electrical isolation resistance between a traction voltage bus **10** and a chassis **P** of the vehicle **1,** and to control how and when the isolation resistance is determined. Typically, the traction voltage bus **10** is provided to distribute electrical power from an energy storage system **12,** such as a battery or a fuel cell system, to one or more electrical loads such as one or more electrical traction motors **14.** The vehicle **1** is programmed to control the isolation resistance monitoring system **200,** as will be described further in the following.

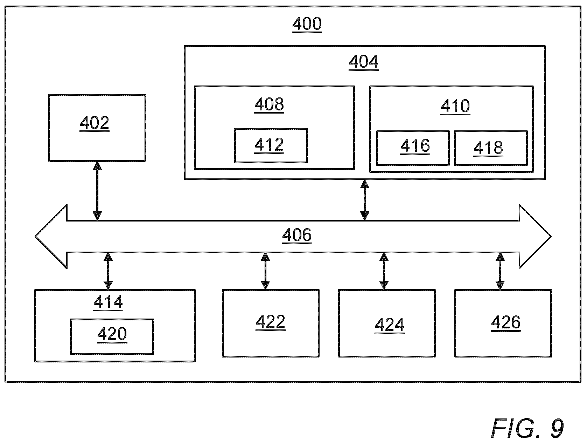

The vehicle **1** comprises, at least to some extent, processing circuitry **110** forming part of a computer system **100** (see **FIG. 9****).** The processing circuitry **110** is configured to implement the isolation resistance monitoring system **200.**

The vehicle **1** may further comprise communications circuitry **90** configured to receive and/or send communications. The communications circuitry **90** may be configured to enable the vehicle **1** to communicate with one or more external devices or systems such as a cloud server **60.** The communication with the external devices or systems may be directly or via a communications interface such as a cellular communications interface **70,** such as a radio base station. The cloud server **60** may be any suitable cloud server exemplified by, but not limited to, Amazon Web Services (AWS), Microsoft Azure, Google Cloud Platform (GCP), IBM Cloud, Oracle Cloud Infrastructure (OCI), DigitalOcean, Vultr, Linode, Alibaba Cloud, Rackspace etc. The communications interface may be a wireless communications interface exemplified by, but not limited to, Wi-Fi, Bluetooth, Zigbee, Z-Wave, LoRa, Sigfox, 2G (GSM, CDMA), 3G (UMTS, CDMA2000), 4G (LTE), 5G (NR) etc. The communication circuitry **90** may, additionally or alternatively, be configured to enable the vehicle **1** to be operatively connected to a Global Navigation Satellite System (GNSS) **80** exemplified by, but not limited to, global positioning system (GPS), Globalnaya Navigatsionnaya Sputnikovaya Sistema (GLONASS), Galileo, BeiDou Navigation Satellite System, Navigation with Indian Constellation (NavIC) etc. The vehicle **1** may for example be configured to utilize data obtain from the GNSS 80 to determine a geographical location of the vehicle **1.**

The vehicle **1** in **FIG. 1** comprises the computer system **100** and the isolation resistance monitoring system **200.** The computer system **100** may be operatively connected to the isolation resistance monitoring system **200** and optionally to the communications circuitry **90** of the vehicle **1.** The computer system **100** comprises processing circuitry **110.** The computer system **100** may comprise a storage device **120,** advantageously a non-volatile storage device such as a hard disk drives (HDDs), solid-state drives (SSDs) etc. In some examples, the storage device **120** is operatively connected to the computer system **100.** The isolation resistance monitoring system **200** may comprise isolation resistance monitoring system processing circuitry **202;** the isolation resistance monitoring system processing circuitry **202** may be part of the processing circuitry **110** of the computer system 100.

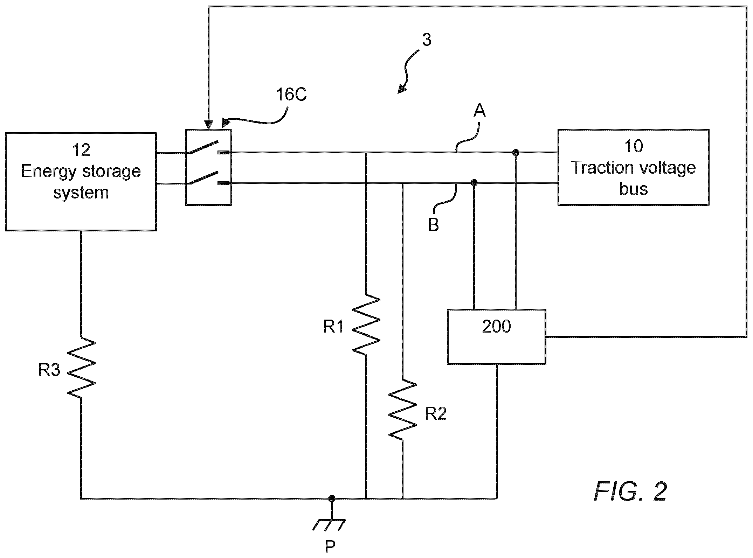

**FIG. 2** is an exemplary schematic view of an electrical system 3 of an at least partly electrically driven vehicle **1,** being monitored by an isolation resistance monitoring system **200.**

The electrical system **3** comprises a traction voltage bus **10** being connected to and receiving or delivering power to an electrical energy system **12,** such as a battery, a fuel cell system, a supercapacitor, or a load device. Typically, the energy storage system **12** connects to the traction voltage bus **10.** The traction voltage bus **10** has a positive pole **A** and a negative pole **B.** Further, the energy storage system **12** may be connected to the traction voltage bus **10** via switchable contactors **18.**

As is further shown in **FIG. 2****,** the energy storage system **12** may be connected to ground **P** via a resistance **R3.** For example, in examples where the energy storage system **12** is a fuel cell system the resistance **R3** may comprise a pump and/or a radiator, etc.

The total resistance between the traction voltage bus **10** and the chassis **P** of the vehicle **1** is represented by the resistances **R1, R2** to which resistance **R3** will be added when contactors **18** close.

The isolation resistance monitoring system **200** is configured to measure these resistances **R1, R2.** This can be done in many different ways, for example by measuring a voltage drop across a test resistor that is connected between one of the poles **A, B** and the chassis **P** of the vehicle **1.**

Hence, in an attempt to minimize this risk of electric shock by implementing the isolation resistance monitoring system **200,** the voltage drop between the positive terminal **A** of the energy storage system **12** and the chassis **P** and the voltage drop between the negative terminal **B** of the energy storage system **12** and the chassis **P** are subsequently measured. Each of these measurements is made after a period of time has elapsed, allowing for the voltage in the circuit to stabilize following the connection of e.g. the test resistor. This is typically due to an RC time constant, which is caused by the test resistor and the suppression and parasitic capacitors present within the system.

The settling (or decay of the voltage change) to steady state is characterized by a very long time constant, typically at least a few seconds to settle on a single asymptote. Ten to fifteen seconds is typical for a complete cycle, with five to seven seconds to settle on each asymptote. The time constant can be attributed to the combined effect of the electromagnetic compatibility suppression filter capacitors, the parasitic capacitance between the chassis **P** and the high voltage positive and negative terminals **A, B,** and the large resistance value typically employed for the test resistor. It is therefore imperative that a sufficiently lengthy interval be allowed to elapse following the connection of the test resistor before undertaking a voltage measurement, in order to ensure the accuracy of the results.

As will be further explained in the following, action on the traction voltage bus **10** may affect the voltage between the poles **A, B** and the chassis **P.** Such action may for example by the contactors **18** opening or closing. Another effect may be the level of polarisation in system **12** which will affect how **R3** is distributed. Another affect may be temperature/coolant conductivity which may affect the magnitude of **R3.** Subsystems in **12** may also be a factor affecting **R3.** Changes to **R1** or **R2** are seen as local incidences of the invention. Change in **A-B** voltage will also affect **A-P** and **B-P** voltage. Due to this interference, the isolation resistance monitoring system **200** is communicating with components that may have this effect. In the shown example the isolation resistance monitoring system **200** is connected to the contactors **18,** however the communication may be with any vehicle component directly or indirectly being responsible for the control of any electrical component that may affect the voltage drop.

Especially, the isolation resistance monitoring system **200** is configured to apply a switching between the first traction voltage pole **A** and the second traction voltage pole **B** at some switching frequency. The isolation resistance monitoring system **200** is further configured to receive or obtain information alerting it that an event expected to disturb isolation resistances and/or pole-to-chassis voltages has occurred or is expected to occur and ideally also the nature of the event, pole(s) affected, and preferably the voltage or the expected or internally measured resistance attached to this event. It may also be configured to adjust the assumptions made in its internal processes/calculation to suit in addition to being configured to potentially adjusting switching strategy/frequency. If this predicted or estimated chassis voltage shift is expected to disturb the chassis voltage, the timing of the switch and/or the voltage shift is adjusted such that any disturbance is avoided. Receiving and acting on event information (also internal detection of the same information) is about resolving transient deviations between the actual conditions and the assumptions normally being used in the isolation resistance monitoring and can also include some means to minimize some disturbance. For example, transient deviation is an event occurring within the alternating two-point-two-measurement cycle and hence unavoidable. Responsive adjustment of isolation resistance monitoring switching (whether external info or internal detection) is about minimizing the effect of disturbances but does not address the transient deviation issue. Scheduling of events or isolation resistance monitoring switching can essentially avoid disturbance but again does not address the transient deviation issue.

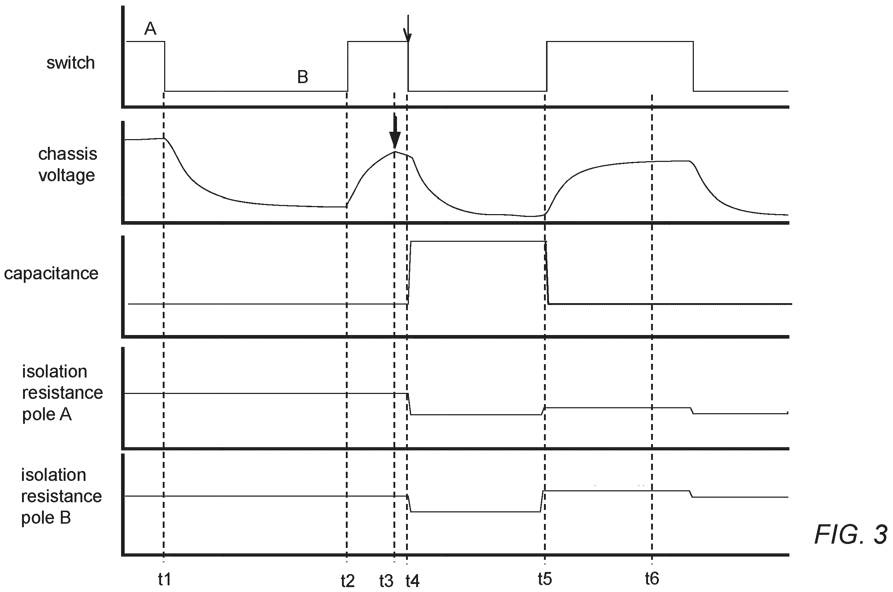

**FIG. 3** shows a series of charts illustrating an exemplary sequence of measurements by an isolation resistance monitoring system **200.** The top diagram shows the switching sequence between the first traction voltage pole **A** and the second traction voltage pole **B.**

The next diagram shows a pole-chassis voltage, i.e. **A-P** or **B-P** differential, being measured by the isolation resistance monitoring system **200.**

The next diagram is showing a capacitance calculated by the isolation resistance monitoring system **200,** and the bottom two diagrams show the calculated isolation resistance between the first traction voltage pole **A** and the chassis **P,** and between the second traction voltage pole **B** and the chassis **P,** respectively.

At time **t1,** the isolation resistance monitoring system **200** switches from the first traction voltage pole **A** to the second traction voltage pole **B.** The chassis voltage will start to drop slowly, while the values of the capacitance and the isolation resistances are not updated. The chassis voltage will continue to drop until it reaches an asymptotic condition towards the correct voltage level. At time **t2** the isolation resistance monitoring system **200** switches from the second traction voltage pole **B** to the second traction voltage pole **A.** The measured chassis voltage will start to increase towards the previous level, while the values of the capacitance and the isolation resistances are not updated. However at time **t3,** a sudden action affecting the resistance between the first traction voltage pole **A** and chassis **P** only causes the measured chassis voltage to depart from its increasing behavior and instead start to drop slightly, while the values of the capacitance and the isolation resistances are not updated. At time **t4,** shortly after time **t3,** another switching occurs to the second traction voltage pole **B.** This early switching is due to the non-characteristic behavior of the pole-chassis voltage vs time curve tending toward zero early, indicating an early settling of the value and potentially causing an irrelevant value to be selected (a cause of disturbance error) if so extreme as to cause the curve reverse unexpectedly as shown. As this no longer adheres to the characteristic curve of a capacitor. Hence the capacitance calculation may fail, leading to a wrong, undefined or out of range value of the capacitance. A calculation of resistance based on the voltage at **t2** (deviant from assumption) and that at **t3** (disturbed) (or **t4)** indicates that total isolation resistance (proportional to the peak-peak amplitude of the pole-chassis voltage) has diminished significantly and while the symmetry (proportional to average pole-chassis voltage) can not move enough to project this onto pole **A** resistance alone.. When **t5** measurement arrives and replaces **t2** in the calculation the total resistance improves, but to an over-estimate since **t3** was disturbed and taken above the asymptote at **t6.** The drop in **t5** vs **t2** largely fixes the symmetry (though **t3** limits this). At **t6** an accurate measurement results since **t5** and **t6** are both clear of the event..

In order to avoid situations as described above, the isolation resistance monitoring system **200** is configured to operate an alternate process upon receiving information from another system advising of the change it has made, more specifically in this example that resistance **A-P** has been changed and **B-P** has not which allows a calculation assuming the resistance **B-P** from **t2** holds (instead of the voltage from **t2** which is now inconsistent).

Furthermore, the isolation resistance monitoring system **200** may be configured to apply an improved strategy between the switching of first/second traction voltage poles **A, B** to avoid the wrong voltage being detected/assigned at the disturbance **t3** and furthermore arbitration strategies may be applied where it is possible to ensure a safe and optimized synchronization of events and communications and switch events to facilitate valid assumptions and the avoidance or minimization of disturbances.

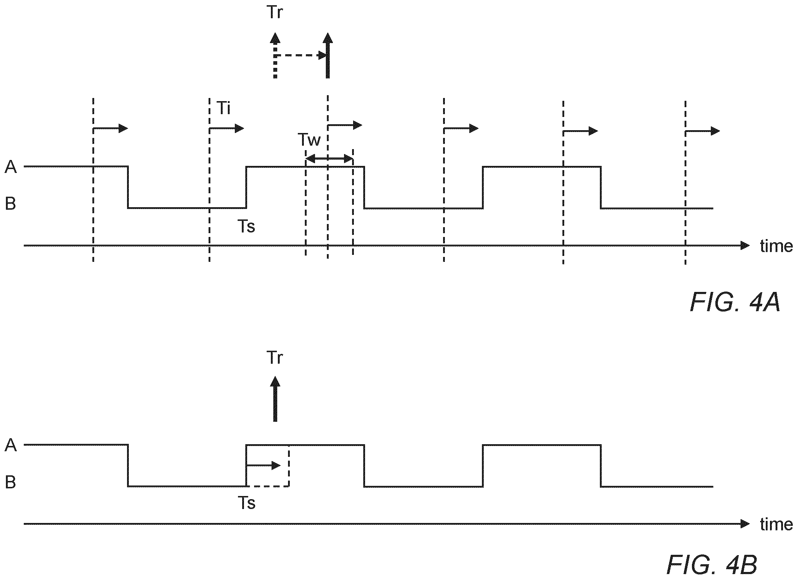

**FIG. 4A** is a diagram showing examples of the methodology applied by an isolation resistance monitoring system **200** according to one example. The solid square wave represents which of the first and second traction voltage poles **A, B** being switched on. As can be seen, initially the chassis voltage is measured against the first traction voltage pole **A** and is thereafter changed to the second traction voltage pole **B.** The voltage across at least two of the three poles **A-B, A-P, B-P** is measured or otherwise known and monitored (so voltage division can be assessed and because **V_{A-B}** = **V_{A-P}** + **V_{B-P}**). Since **V_{A-B}** (i.e. the actual traction voltage) is pretty core it is usually this against one of the other pairs. The voltage measurement is not switched but which pole is being connected to ground via a known resistance is. The time **Ts** represents a scheduled switching time from voltage traction pole **B** to traction voltage pole **A.** Time **Tr** represents an expected shift on the chassis voltage. The expected shift **Tr** may be determined based on control data from any suitable component of the vehicle **1,** such as a battery management system requesting contactors to open or close, etc. The most applicable example may be something repeatable and non-consequential like another test circuit or dummy leakage being used to discern a subset of resistances from the wider network, although contactors could be relevant as an example. A further parameter **Ti** represents a time interval, or time window, during which it is assumed to be possible to handle a shift on the chassis voltage without it causing any disturbance to measurements on chassis voltage, capacitance, or isolation resistance on any of the poles **A, B.** Typically, the time window **Ti** begins when the chassis voltage is exhibiting an asymptotic behavior. In the shown example, the expected shift **Tr** is outside the time interval **Ti.**

In the shown example, the isolation resistance monitoring system **200** is configured to adjust the requested shift time **Tr** by postponing it until a time that is inside the next time interval **Ti.**

In **FIG. 4A** a further parameter, a time window **Tw,** is indicated. The time window **Tw** may represent a maximum allowed time span for delaying the scheduled switching time **Ts** and/or the time request **Tr.**

In **FIG. 4B** another example is shown. The normal switching sequence of the traction voltage poles **A, B** is shown in solid lines. The requested shift on the chassis voltage is expected to occur shortly after a switching action, which would likely cause an undesired disturbance on the monitoring. In response, the isolation resistance monitoring system **200** is configured to adjust the switching sequence such that a current switching period is extended, as indicated by the dashed lines. Hence, the requested shift on the chassis voltage, indicated by time **Tr,** is occurring at the end of the switching period where the chassis voltage likely exhibits the desired asymptotic behavior.

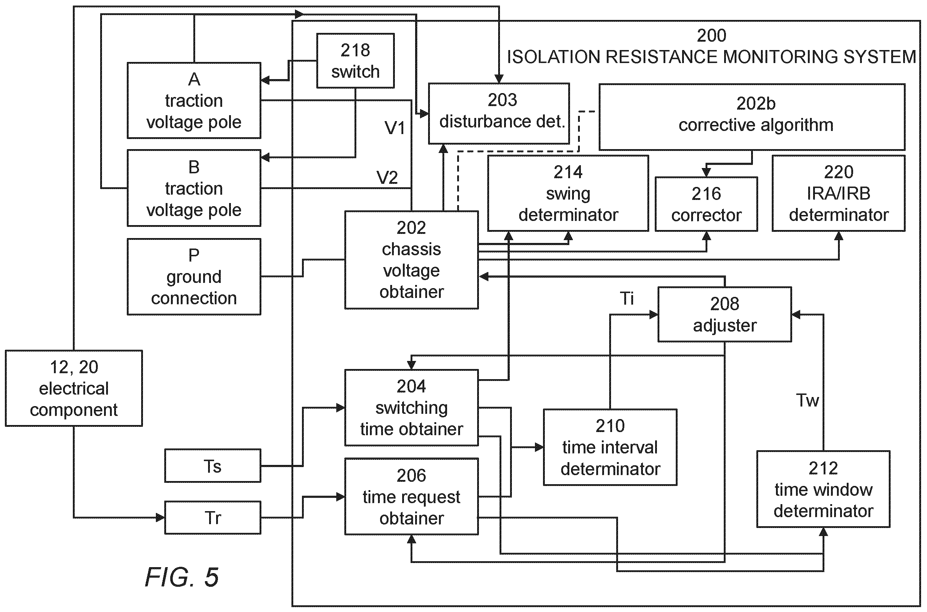

In **FIG. 5** an example of an isolation resistance monitoring system **200** is schematically shown. The isolation resistance monitoring system **200** comprises a chassis voltage obtainer **202.** The chassis voltage obtainer **202** is configured to obtain a chassis voltage **V1** between a first traction voltage pole **A** and a chassis **P** of a vehicle **1.** The isolation resistance monitoring system **200** further comprises a switching time obtainer **204.** The switching time obtainer **204** is configured to obtain a scheduled switching time **Ts** to switch from the first traction voltage pole **A** to the second traction voltage pole **B** in order to measure a chassis voltage **V2** between the second traction voltage pole **B** and the chassis **P** of the vehicle **1.**

The isolation resistance monitoring system **200** comprises a disturbance determinator **203.** The disturbance determinator **203** is configured to determine a disturbance, i.e. a shift, on the chassis voltage between any of the poles **A, B.** The disturbance may be an occurring disturbance or a scheduled disturbance, i.e. the disturbance determinator **203** may receive data from the chassis voltage obtainer **202** representing information that a disturbance has occurred, or the disturbance determinator **203** may receive data from any associated component or hardware (such as an electrical component **20)** that a disturbance is about to happen. Preferably, such data is also comprising data of the expected timing of the disturbance, i.e. a time request as will be further explained below.

The chassis voltage obtainer **202** is further configured to determine and/or adjust corrective algorithm **202b** based on the determined disturbance. The corrective algorithm **202b** is preferably based on the obtained voltage and/or the determined disturbance. Typically, the corrective algorithm **202b** is selected as one of i) adapt calculation of chassis voltage, ii) adapt switch timing, iii) request delay or adjust timing of disturbance, or iv) neglect disturbance.

The isolation resistance monitoring system **200** comprises a time request obtainer **206.** The time request obtainer **206** is configured to obtain a time request **Tr** for a predicted shift (or disturbance) of the chassis voltage **V1**, **V2** occurring at the scheduled switching time **Ts.** The time request obtainer **206** is specifically configured to obtain the time request **Tr** for an electrical connection of a vehicle component to the traction voltage pole **A, B.** Further, the isolation resistance monitoring system **200** comprises an adjuster **208.** The adjuster **208** is configured to adjust the timing of at least one of the scheduled switching time **Ts** and the time request **Tr.**

The chassis voltage obtainer **202** is further configured to obtain the chassis voltage **V2** between the second traction voltage pole **B** and the chassis **P** of the vehicle 1 after the scheduled switching time **Ts,** preferably by applying the corrective algorithm. Hence, the chassis voltage **V2** will be obtained after the scheduled switching time **Ts** and/or the timing of the scheduled shift of the chassis voltage has been adjusted, or at the initial timings but using the corrective algorithm **202b.**

The isolation resistance monitoring system **200** further comprises a time interval determinator **210.** The time interval determinator **210** is configured to determine that the time request **Tr** for the predicted shift of the chassis voltage **V1** is within a predetermined time interval **Ti** relative the scheduled switching time **Ts.** Based on this, the adjuster **208** is configured to adjust at least one of the scheduled switching time **Ts** and the time request **Tr** such that the time request **Tr** for the predicted shift of the chassis voltage **V1** is outside the predetermined time interval **Ti.**

The adjuster **208** is configured to adjust at least one of the scheduled switching time **Ts** and the time request **Tr** by delaying the scheduled switching time **Ts,** and/or by delaying the electrical connection of a vehicle component **12, 20** to the traction voltage pole **A, B.**

The isolation resistance monitoring system **200** further comprises a time window determinator **212.** The time window determinator **212** is configured to determine a time window **Tw.** Based on the determined time window **Tw,** the adjuster **208** is configured to adjust at least one of the scheduled switching time **Ts** and the time request **Tr** by effecting the switch from the first traction voltage pole **A** to a second traction voltage pole **B** and/or the electrical connection of a vehicle component to the first traction voltage pole **A** within said time window **Tw.** Hence, the time window **Tw** may represent a maximum allowed time span for delaying the scheduled switching time **Ts** and/or the time request **Tr.** The time window **Tw** may for example be determined based on the normal switching frequency of the isolation resistance monitoring system **200.**

The isolation resistance monitoring system **200** may further comprise a swing determinator **214.** The swing determinator **214** is configured to determine that the chassis voltage **V1** is swinging, which may correspond to the chassis voltage **V1** departing from a normal, or ideal, behavior. Further, the swing determinator **214** may be configured to determine that the scheduled switching time **Ts** of the chassis voltage coincides with the swinging behavior of the chassis voltage **V1**.

The isolation resistance monitoring system **200** may further comprise a corrector **216.** The corrector **216** is configured to apply a correction factor to the obtained chassis voltage **V2.** For such example, the isolation resistance monitoring system **200** comprises a switch **218** configured to switch from the first traction voltage pole **A** to the second traction voltage pole **B** at a non-ideal shift of the obtained chassis voltage **V1.** After obtaining the chassis voltage **V2** between the second traction voltage pole **B** and the chassis **P** of the vehicle **1,** the corrector **216** is configured to correct the obtained chassis voltage **V2** between the second traction voltage pole **B** and the chassis **P** of the vehicle **1** based on the non-ideal shift of the obtained chassis voltage **V1**. In some examples, the corrector **216** is configured to suppress the obtained chassis voltage **V2** between the second traction voltage pole **B** and the chassis **P** of the vehicle **1** based on the non-ideal shift of the obtained chassis voltage **V1.** The corrector **216** may preferably operate by applying the selected corrective algorithm **202b.**

The isolation resistance monitoring system **200** further comprises an isolation resistance determinator **220.** The isolation resistance determinator **220** is configured to determine an isolation resistance **IRA** between the first traction voltage pole **A** and the chassis **P** of the vehicle **1** based on the measured chassis voltage **V1,** and to determine an isolation resistance **IRB** between the second traction voltage pole **B** and the chassis **P** of the vehicle **1** based on the measured chassis voltage **V2.**

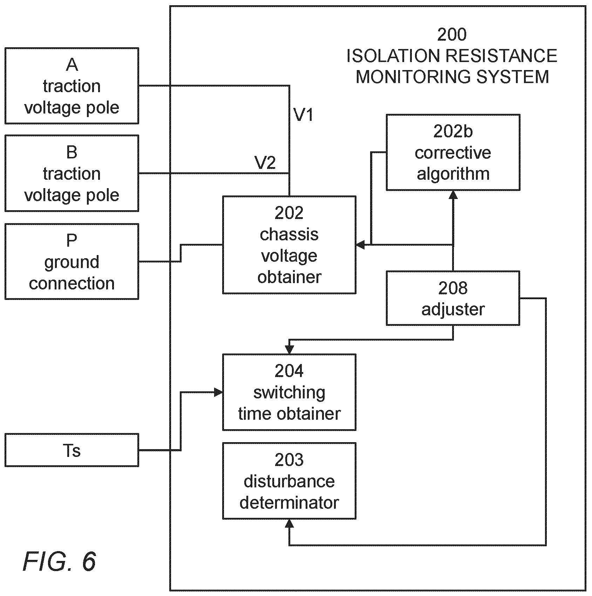

In **FIG. 6** an example of an isolation resistance monitoring system **200** is schematically shown. The isolation resistance monitoring system **200** comprises a chassis voltage obtainer **202.** The chassis voltage obtainer **202** is configured to obtain a chassis voltage **V1** between a first traction voltage pole **A** and a chassis **P** of a vehicle **1.** The isolation resistance monitoring system **200** further comprises a switching time obtainer **204.** The switching time obtainer **204** is configured to obtain a scheduled switching time **Ts** to switch from the first traction voltage pole **A** to the second traction voltage pole **B** in order to measure a chassis voltage **V2** between the second traction voltage pole **B** and the chassis **P** of the vehicle **1.**

The isolation resistance monitoring system **200** comprises a disturbance determinator **203.** The disturbance determinator **203** is configured to determine a disturbance, i.e. a shift, of the chassis voltage **V1, V2.** Further, the isolation resistance monitoring system **200** comprises an adjuster **208.** The adjuster **208** is configured to adjust the timing of the scheduled switching time **Ts** and/ or a corrective algorithm **202b.**

The chassis voltage obtainer **202** is further configured to obtain the chassis voltage **V2** between the second traction voltage pole **B** and the chassis **P** of the vehicle **1** based on the adjusted switching time **Ts** and/or the corrective algorithm **202b.** Hence, the chassis voltage **V2** will be obtainer after the scheduled switching time **Ts** has been adjusted, and/or after applying the corrective algorithm.

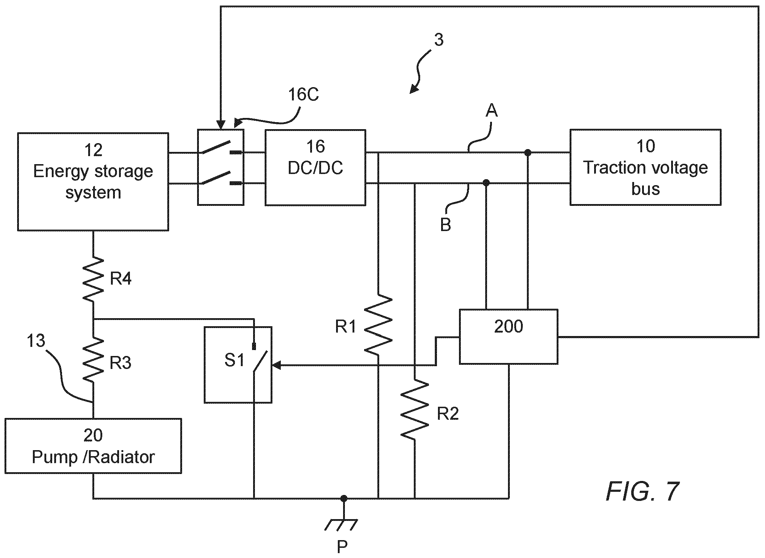

**FIG. 7** shows a further example of an electrical system **3** having an isolation resistance monitoring system **200.** In the shown example, a fluid conduit **13** providing electrical resistance along its length is selectively partially short circuited through a switch **S1.** Proportionality of the path may be used to determine the contribution of the path to the measured total and from this discern the conductivity of the fluid inside the fluid conduit **13..** As timing of the operation of the switch **13** may cause the measured voltage **V_{A-P}**, **V_{B-P}** to depart from its ideal behavior, the isolation resistance monitoring system **200** may be configured to synchronize the operation of the switch **S1** based on how the switching will affect the chassis voltage **V_{A-P}**, **V_{B-P}**.

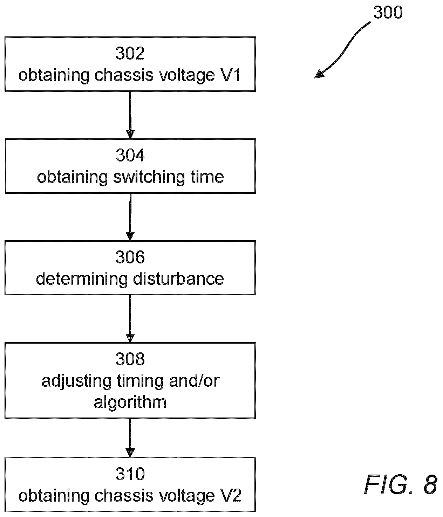

In **FIG. 8** a method **300** for monitoring an electrical system **3** is shown. The method **300** comprises obtaining **302,** by processing circuitry of a computer system, a chassis voltage between a first traction voltage pole and a chassis of a vehicle. The method **300** further comprises obtaining **304,** by the processing circuitry, a scheduled switching time to switch from the first traction voltage pole to the second traction voltage pole in order to measure the chassis voltage between the second traction voltage pole and the chassis of the vehicle. The method **300** comprises determining **306,** by the processing circuitry, a disturbance on the first or second voltage pole and adjusting **308,** by the processing circuitry, the scheduled switching time and/or a corrective algorithm. The method **300** further comprises obtaining **310,** by the processing circuitry, a chassis voltage between the second traction voltage pole and the chassis of the vehicle based on the adjusted scheduled switching time and/or the corrective algorithm.

**FIG. 9** is a schematic diagram of a computer system **400** for implementing examples disclosed herein. The computer system **400** is adapted to execute instructions from a computer-readable medium to perform these and/or any of the functions or processing described herein. The computer system **400** may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system **400** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **400** may comprise at least one computing device or electronic device capable of including firmware, hardware, and/or executing software instructions to implement the functionality described herein. The computer system **400** may include processing circuitry **402** (e.g., processing circuitry including one or more processor devices or control units), a memory **404,** and a system bus **406.** The computer system **400** may include at least one computing device having the processing circuitry **402.** The system bus **406** provides an interface for system components including, but not limited to, the memory **404** and the processing circuitry **402.** The processing circuitry **402** may include any number of hardware components for conducting data or signal processing or for executing computer code stored in memory **404.** The processing circuitry **402** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **402** may further include computer executable code that controls operation of the programmable device.

The system bus **406** may be any of several types of bus structures that may further interconnect to a memory bus (with or without a memory controller), a peripheral bus, and/or a local bus using any of a variety of bus architectures. The memory **404** may be one or more devices for storing data and/or computer code for completing or facilitating methods described herein. The memory **404** may include database components, object code components, script components, or other types of information structure for supporting the various activities herein. Any distributed or local memory device may be utilized with the systems and methods of this description. The memory **404** may be communicably connected to the processing circuitry **402** (e.g., via a circuit or any other wired, wireless, or network connection) and may include computer code for executing one or more processes described herein. The memory **404** may include non-volatile memory **408** (e.g., read-only memory (ROM), erasable programmable read-only memory (EPROM), electrically erasable programmable read-only memory (EEPROM), etc.), and volatile memory **410** (e.g., random-access memory (RAM)), or any other medium which can be used to carry or store desired program code in the form of machine-executable instructions or data structures and which can be accessed by a computer or other machine with processing circuitry **402.** A basic input/output system (BIOS) **412** may be stored in the non-volatile memory **408** and can include the basic routines that help to transfer information between elements within the computer system **400.**

The computer system **400** may further include or be coupled to a non-transitory computer-readable storage medium such as the storage device **414,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **414** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **414** and/or in the volatile memory **410,** which may include an operating system **416** and/or one or more program modules **418.** All or a portion of the examples disclosed herein may be implemented as a computer program **420** stored on a transitory or non-transitory computer-usable or computer-readable storage medium (e.g., single medium or multiple media), such as the storage device **414,** which includes complex programming instructions (e.g., complex computer-readable program code) to cause the processing circuitry **402** to carry out actions described herein. Thus, the computer-readable program code of the computer program **420** can comprise software instructions for implementing the functionality of the examples described herein when executed by the processing circuitry **402.** In some examples, the storage device **414** may be a computer program product (e.g., readable storage medium) storing the computer program **420** thereon, where at least a portion of a computer program **420** may be loadable (e.g., into a processor) for implementing the functionality of the examples described herein when executed by the processing circuitry **402.** The processing circuitry **402** may serve as a controller or control system for the computer system **400** that is to implement the functionality described herein.

The computer system **400** may include an input device interface **422** configured to receive input and selections to be communicated to the computer system **400** when executing instructions, such as from a keyboard, mouse, touch-sensitive surface, etc. Such input devices may be connected to the processing circuitry **402** through the input device
interface **422** coupled to the system bus **406** but can be connected through other interfaces, such as a parallel port, an Institute of Electrical and Electronic Engineers (IEEE) 1394 serial port, a Universal Serial Bus (USB) port, an IR interface, and the like. The computer system **400** may include an output device interface **424** configured to forward output, such as to a display, a video display unit (e.g., a liquid crystal display (LCD) or a cathode ray tube (CRT)). The computer system **400** may include a communications interface **426** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

**Example 1.** A computer system comprising processing circuitry configured to: obtain a chassis voltage (V1) between a first traction voltage pole (A) and a chassis (P) of a vehicle (1); obtain a scheduled switching time (Ts) to switch from the first traction voltage pole (A) to the second traction voltage pole (B) in order to measure the chassis voltage (V2) between the second traction voltage pole (B) and the chassis (P) of the vehicle (1); determine a disturbance on the first or second traction voltage pole (A, B); adjust the scheduled switching time (Ts) and/or a corrective algorithm; and obtain a chassis voltage (V2) between the second traction voltage pole (B) and the chassis (P) of the vehicle (1) based on the adjusted switching time (Ts) and/or the corrective algorithm.

**Example 2.** The computer system of Example 1, wherein the processing circuitry is further configured to determine the disturbance as a scheduled disturbance or an occurring disturbance on the first or second traction voltage pole (A, B).

**Example 3.** The computer system of Example 1 or 2, wherein the processing circuitry is further configured to obtain a time request (Tr) for a predicted shift of the chassis voltage occurring at the scheduled switching time.

**Example 4.** The computer system of any of Examples 1-3, wherein the processing circuitry is further configured to: determine that the time request (Tr) for the predicted shift of the chassis voltage (V1) is within a predetermined time interval (Ti) relative the scheduled switching time (Ts), and adjust at least one of the scheduled switching time (Ts) and the time request (Tr) such that the time request (Tr) for the predicted shift of the chassis voltage (V1) is outside the predetermined time interval (Ti).

**Example 5.** The computer system of any of Examples 3-4, wherein the processing circuitry is further configured to: obtain the time request (Tr) for the predicted shift of the chassis voltage (V1) by obtaining a time request (Tr) for an electrical connection of a vehicle component (10) to the first traction voltage pole (A).

**Example 6.** The computer system of any of Examples 3-5, wherein the processing circuitry is further configured to: adjust at least one of the scheduled switching time (Ts) and the time request (Tr) by delaying the scheduled switching time (Ts).

**Example 7.** The computer system of any of Examples 3-6, wherein the processing circuitry is further configured to: adjust at least one of the scheduled switching time (Ts) and the time request (Tr) by delaying the electrical connection of a vehicle component (10) to the first traction voltage pole (A).

**Example 8.** The computer system of any of Examples 3-7, wherein the processing circuitry is further configured to: determine a time window (Tw), and adjust at least one of the scheduled switching time (Ts) and the time request (Tr) by effecting the switch from the first traction voltage pole (A) to a second traction voltage pole (B) and/or the electrical connection of a vehicle component (10) to the first traction voltage pole (A) within said time window.

**Example 9.** The computer system of any of Examples 3-8, wherein the processing circuitry is further configured to: determine that the chassis voltage (V1) is swinging; wherein the time request (Tr) for the predicted shift of the chassis voltage (V1) coincides with the swinging behavior of the chassis voltage (V1).

**Example 10.** The computer system of any of Examples 1-9, wherein the processing circuitry is further configured to: switch from the first traction voltage pole (A) to a second traction voltage pole (B) at a non-ideal shift of the obtained chassis voltage (V1); obtain a chassis voltage (V2) between a second traction voltage pole (B) and the chassis (P) of the vehicle (1); and correct the obtained chassis voltage (V2) between the second traction voltage pole (B) and the chassis (P) of the vehicle (1) based on the non-ideal shift of the obtained chassis voltage (V1).

**Example 11.** The computer system of Example 10, wherein the processing circuitry is further configured to: suppress the obtained chassis voltage (V2) between the second traction voltage pole (B) and the chassis (P) of the vehicle (1) based on the non-ideal shift of the obtained chassis voltage (V1).

**Example 12.** The computer system of any of Examples 1-11, wherein the processing circuitry is further configured to: determine an isolation resistance (IRA) between the first traction voltage pole (A) and the chassis (P) of the vehicle (1) based on the measured chassis voltage (V1), and determine an isolation resistance (IRB) between the second traction voltage pole (B) and the chassis (P) of the vehicle (1) based on the measured chassis voltage (V2).

**Example 13.** The computer system of Example 1, wherein the processing circuitry is further configured to: determine the disturbance as a scheduled disturbance or an occurring disturbance on the first or second traction voltage pole; obtain a time request for a predicted shift of the chassis voltage occurring at the scheduled switching time; determine that the time request (Tr) for the predicted shift of the chassis voltage (V1) is within a predetermined time interval (Ti) relative the scheduled switching time (Ts), and adjust at least one of the scheduled switching time (Ts) and the time request (Tr) such that the time request (Tr) for the predicted shift of the chassis voltage (V1) is outside the predetermined time interval (Ti) and wherein the time request (Tr) is synchronized with the chassis voltage (V1) being asymptotic: obtain the time request (Tr) for the predicted shift of the chassis voltage (V1) by obtaining a time request (Tr) for an electrical connection of a vehicle component (10) to the first traction voltage pole (A); adjust at least one of the scheduled switching time (Ts) and the time request (Tr) by delaying the scheduled switching time (Ts); adjust at least one of the scheduled switching time (Ts) and the time request (Tr) by delaying the electrical connection of a vehicle component (10) to the first traction voltage pole (A); determine a time window (Tw), and adjust at least one of the scheduled switching time (Ts) and the time request (Tr) by effecting the switch from the first traction voltage pole (A) to a second traction voltage pole (B) and/or the electrical connection of a vehicle component (10) to the first traction voltage pole (A) within said time window; determine that the chassis voltage (V1) is swinging; wherein the time request (Tr) for the predicted shift of the chassis voltage (V1) coincides with the swinging behavior of the chassis voltage (V1); switch from the first traction voltage pole (A) to a second traction voltage pole (B) at a non-ideal shift of the obtained chassis voltage (V1); obtain a chassis voltage (V2) between a second traction voltage pole (B) and the chassis (P) of the vehicle (1); and suppress the obtained chassis voltage (V2) between the second traction voltage pole (B) and the chassis (P) of the vehicle (1) based on the non-ideal shift of the obtained chassis voltage (V1); and determine an isolation resistance (IRA) between the first traction voltage pole (A) and the chassis (P) of the vehicle (1) based on the measured chassis voltage (V1), and determine an isolation resistance (IRB) between the second traction voltage pole (B) and the chassis (P) of the vehicle (1) based on the measured chassis voltage (V2).

**Example 14.** A vehicle comprising the computer system of any of Examples 1-13.

**Example 15.** The vehicle of Example 14, further comprising: a traction voltage bus (12) comprising a first traction voltage pole (A) and a second traction voltage pole (B), and an isolation resistance monitoring device (20) configured to monitor the isolation resistance (IRA, IRB) between the voltage bus (12) and a chassis (P) of the vehicle (1), and to selectively switch the connection between the first and second traction voltage poles (A, B).

**Example 16.** A computer-implemented method, comprising: obtaining, by processing circuitry of a computer system, a chassis voltage (V1) between a first traction voltage pole (A) and a chassis (P) of a vehicle (1); obtaining, by the processing circuitry, a scheduled switching time (Ts) to switch from the first traction voltage pole (A) to the second traction voltage pole (B) in order to measure the chassis voltage (V2) between the second traction voltage pole (B) and the chassis (P) of the vehicle (1); determining, by the processing circuitry, a disturbance on the first or second traction voltage pole; adjusting, by the processing circuitry, the scheduled switching time (Ts) and/or a corrective algorithm; and obtaining, by the processing circuitry, a chassis voltage (V2) between the second traction voltage pole (B) and the chassis (P) of the vehicle (1) based on the scheduled switching time (Ts) and/or the corrective algorithm.

**Example 17.** The method of Example 16, further comprising: obtaining a time request (Tr) for a predicted shift of the chassis voltage occurring at the scheduled switching time.

**Example 18.** The method of Example 17, further comprising: determining, by the processing circuitry, that the time request (Tr) for the predicted shift of the chassis voltage (V1) is within a predetermined time interval (Ti) relative the scheduled switching time (Ts), and adjusting, by the processing circuitry, at least one of the scheduled switching time (Ts) and the time request (Tr) such that the time request (Tr) for the predicted shift of the chassis voltage (V1) is outside the predetermined time interval (Ti).

**Example 19.** The method of any of Examples 17-18, further comprising: obtaining, by the processing circuitry, the time request (Tr) for the predicted shift of the chassis voltage (V1) by obtaining a time request (Tr) for an electrical connection of a vehicle component (10) to the first traction voltage pole (A).

**Example 20.** The method of any of Examples 17-19, further comprising: adjusting, by the processing circuitry, at least one of the scheduled switching time (Ts) and the time request (Tr) by delaying the scheduled switching time (Ts).

**Example 21.** The method of any of Examples 17-20, further comprising: adjusting, by the processing circuitry, at least one of the scheduled switching time (Ts) and the time request (Tr) by delaying the electrical connection of a vehicle component (10) to the first traction voltage pole (A).

**Example 22.** A computer program product comprising program code for performing, when executed by the processing circuitry, the method of any of Examples 16-22.

**Example 23.** A non-transitory computer-readable storage medium comprising instructions, which when executed by the processing circuitry, cause the processing circuitry to perform the method of any of Examples 16-22.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system comprising processing circuitry configured to:
obtain a chassis voltage (V1) between a first traction voltage pole (A) and a chassis (P) of a vehicle (1);
obtain a scheduled switching time (Ts) to switch from the first traction voltage pole (A) to the second traction voltage pole (B) in order to measure the chassis voltage (V2) between the second traction voltage pole (B) and the chassis (P) of the vehicle (1);
determine a disturbance on the first or second traction voltage pole;
adjust the scheduled switching time (Ts) and/or a corrective algorithm; and
obtain a chassis voltage (V2) between the second traction voltage pole (B) and the chassis (P) of the vehicle (1) based on the adjusted scheduled switching time (Ts) and/or the corrective algorithm.

2. The computer system of claim 1, wherein the processing circuitry is further configured to:
determine the disturbance as a scheduled disturbance or an occurring disturbance on the first or second traction voltage pole.

3. The computer system of claim 1 or 2, wherein the processing circuitry is further configured to:
obtain a time request for a predicted shift of the chassis voltage occurring at the scheduled switching time.

4. The computer system of claim 3, wherein the processing circuitry is further configured to:
determine that the time request (Tr) for the predicted shift of the chassis voltage (V1) is within a predetermined time interval (Ti) relative the scheduled switching time (Ts), and
adjust at least one of the scheduled switching time (Ts) and the time request (Tr) such that the time request (Tr) for the predicted shift of the chassis voltage (V1) is outside the predetermined time interval (Ti).

5. The computer system of any of claims 3-4, wherein the processing circuitry is further configured to:
obtain the time request (Tr) for the predicted shift of the chassis voltage (V1) by obtaining a time request (Tr) for an electrical connection of a vehicle component (10) to the first traction voltage pole (A).

6. The computer system of any of claims 3-5, wherein the processing circuitry is further configured to:
adjust at least one of the scheduled switching time (Ts) and the time request (Tr) by delaying the scheduled switching time (Ts), and/or
adjust at least one of the scheduled switching time (Ts) and the time request (Tr) by delaying the electrical connection of a vehicle component (10) to the first traction voltage pole (A).

7. The computer system of any of claims 3-6, wherein the processing circuitry is further configured to:
determine a time window (Tw), and
adjust at least one of the scheduled switching time (Ts) and the time request (Tr) by effecting the switch from the first traction voltage pole (A) to a second traction voltage pole (B) and/or the electrical connection of a vehicle component (10) to the first traction voltage pole (A) within said time window.

8. The computer system of any of claims 3-7, wherein the processing circuitry is further configured to:
determine that the chassis voltage (V1) is swinging; wherein
the time request (Tr) for the predicted shift of the chassis voltage (V1) coincides with the swinging behavior of the chassis voltage (V1).

9. The computer system of any of claims 1-8, wherein the processing circuitry is further configured to:
switch from the first traction voltage pole (A) to a second traction voltage pole (B) at a non-ideal shift of the obtained chassis voltage (V1);
obtain a chassis voltage (V2) between a second traction voltage pole (B) and the chassis (P) of the vehicle (1); and
correct the obtained chassis voltage (V2) between the second traction voltage pole (B) and the chassis (P) of the vehicle (1) based on the non-ideal shift of the obtained chassis voltage (V1).

10. The computer system of claim 9, wherein the processing circuitry is further configured to:
suppress the obtained chassis voltage (V2) between the second traction voltage pole (B) and the chassis (P) of the vehicle (1) based on the non-ideal shift of the obtained chassis voltage (V1), and/or wherein the processing circuitry is further configured to:
determine an isolation resistance (IRA) between the first traction voltage pole (A) and the chassis (P) of the vehicle (1) based on the measured chassis voltage (V1), and determine an isolation resistance (IRB) between the second traction voltage pole (B) and the chassis (P) of the vehicle (1) based on the measured chassis voltage (V2).

11. The computer system of claim 1, wherein the processing circuitry is further configured to:
determine the disturbance as a scheduled disturbance or an occurring disturbance on the first or second voltage pole;
obtain a time request for a predicted shift of the chassis voltage occurring at the scheduled switching time;
determine that the time request (Tr) for the predicted shift of the chassis voltage (V1) is within a predetermined time interval (Ti) relative the scheduled switching time (Ts), and
adjust at least one of the scheduled switching time (Ts) and the time request (Tr) such that the time request (Tr) for the predicted shift of the chassis voltage (V1) is outside the predetermined time interval (Ti) and wherein the time request (Tr) is synchronized with the chassis voltage (V1) being asymptotic:
obtain the time request (Tr) for the predicted shift of the chassis voltage (V1) by obtaining a time request (Tr) for an electrical connection of a vehicle component (10) to the first traction voltage pole (A);
adjust at least one of the scheduled switching time (Ts) and the time request (Tr) by delaying the scheduled switching time (Ts);
adjust at least one of the scheduled switching time (Ts) and the time request (Tr) by delaying the electrical connection of a vehicle component (10) to the first traction voltage pole (A);
determine a time window (Tw), and
adjust at least one of the scheduled switching time (Ts) and the time request (Tr) by effecting the switch from the first traction voltage pole (A) to a second traction voltage pole (B) and/or the electrical connection of a vehicle component (10) to the first traction voltage pole (A) within said time window;
determine that the chassis voltage (V1) is swinging; wherein
the time request (Tr) for the predicted shift of the chassis voltage (V1) coincides with the swinging behavior of the chassis voltage (V1);
switch from the first traction voltage pole (A) to a second traction voltage pole (B) at a non-ideal shift of the obtained chassis voltage (V1);
obtain a chassis voltage (V2) between a second traction voltage pole (B) and the chassis (P) of the vehicle (1); and
suppress the obtained chassis voltage (V2) between the second traction voltage pole (B) and the chassis (P) of the vehicle (1) based on the non-ideal shift of the obtained chassis voltage (V1); and
determine an isolation resistance (IRA) between the first traction voltage pole (A) and the chassis (P) of the vehicle (1) based on the measured chassis voltage (V1), and determine an isolation resistance (IRB) between the second traction voltage pole (B) and the chassis (P) of the vehicle (1) based on the measured chassis voltage (V2).

12. A vehicle comprising the computer system of any of claims 1-11.

13. A computer-implemented method, comprising:
obtaining, by processing circuitry of a computer system, a chassis voltage (V1) between a first traction voltage pole (A) and a chassis (P) of a vehicle (1);
obtaining, by the processing circuitry, a scheduled switching time (Ts) to switch from the first traction voltage pole (A) to the second traction voltage pole (B) in order to measure the chassis voltage (V2) between the second traction voltage pole (B) and the chassis (P) of the vehicle (1);
determining, by the processing circuitry, a disturbance on the first or second traction voltage pole;
adjusting, by the processing circuitry, the scheduled switching time (Ts) and/or a corrective algorithm; and
obtaining, by the processing circuitry, a chassis voltage (V2) between the second traction voltage pole (B) and the chassis (P) of the vehicle (1) based on the adjusted scheduled switching time (Ts) and/or the corrective algorithm.

14. A computer program product comprising program code for performing, when executed by the processing circuitry, the method of claim 13.

15. A non-transitory computer-readable storage medium comprising instructions, which when executed by the processing circuitry, cause the processing circuitry to perform the method of claim 13.
